(19) Europäisches Patentamt / European Patent Office / Office européen des brevets

(11) **EP 4 362 626 A1**

(12) **EUROPEAN PATENT APPLICATION**

(43) Date of publication:
**01.05.2024 Bulletin 2024/18**

(21) Application number: **22204792.0**

(22) Date of filing: **31.10.2022**

(51) International Patent Classification (IPC):
**H10B 61/00** (2023.01)    **H10N 50/01** (2023.01)
**H10N 50/10** (2023.01)

(52) Cooperative Patent Classification (CPC):
**H10N 50/01; H10B 61/00; H10N 50/10**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Commissariat à l'énergie atomique et aux énergies alternatives**
  **75015 Paris (FR)**
• **Centre national de la recherche scientifique**
  **75016 Paris (FR)**
• **Université Grenoble Alpes**
  **38400 Saint-Martin-d'Hères (FR)**
• **Institut Polytechnique de Grenoble**
  **38000 Grenoble (FR)**

(72) Inventors:
• **Fernandes Caçoilo, Nuno-Filipe**
  **38054 GRENOBLE CEDEX 09 (FR)**
• **Prejbeanu, Ioan-Lucian**
  **38054 GRENOBLE CEDEX 09 (FR)**
• **Fruchart, Olivier**
  **38054 GRENOBLE CEDEX 09 (FR)**
• **Dieny, Bernard**
  **38054 GRENOBLE CEDEX 09 (FR)**
• **Sousa, Ricardo**
  **38054 GRENOBLE CEDEX 09 (FR)**

(74) Representative: **Cabinet Camus Lebkiri**
  **25 rue de Maubeuge**
  **75009 Paris (FR)**

(54) **MAGNETIC DEVICE AND CORRESPONDING METHOD**

(57)    An aspect of the invention concerns a method to fabricate a magnetic device (4) from a dielectric layer (3) having a through-hole, so called "via", the method comprising:
- forming a tunnel junction (41) on the dielectric layer (3) comprising:
- a first magnetic layer, intended to form a said "free layer" (411); and
- a second magnetic layer, intended to form a said "reference layer" (412),
- an insulator layer, intended to form a "tunnel barrier" (413);
the free layer (411) or the reference layer (412) being located in the via and being surrounded by the dielectric layer (3).

Fig. 13

EP 4 362 626 A1

**Description**

**TECHNICAL DOMAIN OF THE INVENTION**

The technical field of the invention concerns magnetic tunnel junctions such as one being implemented in magnetic random-access memories and the like or magnetic sensors and the like, and more specifically, it concerns magnetic tunnel junctions having an out-of-plane orientation of the magnetization.

**PRIOR ART**

The spin-transfer torque magnetic random-access memory (or "STT-MRAM") is one of the most promising emerging non-volatile memory technologies. It combines non-volatility with a quasi-infinite write endurance, high speed, low power consumption and scalability. These properties have stimulated the commercial production of STT-MRAM for a variety of stand-alone and embedded applications, in particular NOR flash memory replacement and last-level cache static RAM (or "SRAM") replacement.

A STT-RAM is based on a magnetic tunnel junction (or "junction" or "MTJ"), said junction comprising a reference layer and a free layer, separated by a tunnel layer. The reference layer has a magnetization with a fixed orientation and the free layer has a magnetization with a switchable orientation. Nowadays a junction relies on out-of-plane orientation of the magnetizations in the free and the reference layers (the out-of-plane orientation being considered with respect to the plane of the free layer of junction). This has been shown to lead to a better scalability of the thermal stability factor $\Delta$

$$\Delta = \frac{E_B}{k_B\, T}$$

where $E_B$ is the energy barrier one needs to overcome to reverse the magnetization from an out-of-plane orientation to an opposite one, $k_B$ is the Boltzmann constant and $T$ is the operating temperature. The thermal stability factor determines the memory retention time and impacts the switching current needed to switch the magnetization from one orientation to another one.

Specific devices, called perpendicular magnetic tunnel junction (or "perpendicular junction" or "p-MTJ"), rely on the use of an interfacial magnetic anisotropy existing at the interface between a free layer, usually based on FeCo(B), and a MgO layer (such as the tunnel barrier). The interfacial magnetic anisotropy tends to overcome the shape to orient the magnetization out of the plane of the free layer.

Nonetheless, further downsize scalability of these perpendicular junction below sub-20 nm diameters faces a fundamental challenge. As the diameter of the junction shrinks, there is a decrease of the thermal stability factor $\Delta$ brought by the interfacial perpendicular magnetic anisotropy. This can be understood considering that the interfacial perpendicular magnetic anisotropy is roughly proportional to the surface of the interface between the MgO layer and the free layer.

A proposal to counter this decrease of stability is to add FeCoB/MgO interfaces to increase the total surface providing the interfacial perpendicular magnetic anisotropy. Nevertheless, this approach is quite restrictive in terms of material choice, dependent on the quality of the several interfaces and has a strong dependence with temperature.

To maintain a high thermal stability factor at low technological nodes, the document [N. Perrissin & al., "A highly thermally stable sub-20 nm magnetic random-access memory based on perpendicular shape anisotropy", Nanoscale 10, 12187-12195 (2018)] suggests taking advantage of the shape anisotropy of the free layer by increasing its thickness to values of the order or larger than the free layer diameter. Thereby, the shape anisotropy of the free layer no longer promotes an easy-plane orientation but further stabilizes the magnetization along a perpendicular orientation (with respect to the plane of the free layer). This can be understood considering the magnetostatic energy of a magnetized cylinder, as expressed in [M. Beleggia et al., "Demagnetizing factors for cylindrical shells and related shapes", Journal of Magnetism and Magnetic Materials 321, 1306-1315 (2009)]:

$$E_m = \frac{\mu_0\, M_0^2\, r^3}{6}\left[4(3m_z^2 - 1) + 6\pi\tau m_z^2 - 3\pi\sqrt{1+\tau^2}(3m_z^2 - 1)\,\Gamma_2^1\left(-\frac{1}{2},\frac{3}{2};2;\frac{1}{1+\tau^2}\right)\right]$$

with $\tau$ the ratio $\dfrac{L}{2r}$ ($L$ being the thickness of the free layer and r its radius), $\Gamma_2^1$ a hypergeometric function, and $m_z$ the defined orientation of the magnetization of the free layer with a saturation magnetisation $M_0$ and a vacuum permeability $\mu_0$.

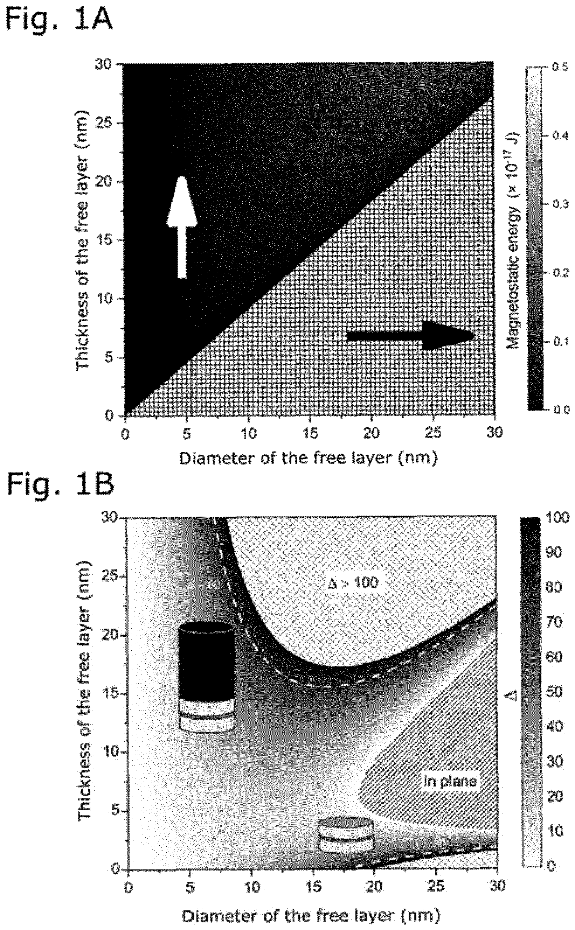

The Fig. 1a shows an example of the magnetostatic energy of a free layer against its aspect ratio (thickness against diameter) considering two distinct orientations of the magnetization (in the plane of said free layer and perpendicular to the said plane). Results are obtained considering a uniform magnetization of 1MA/m. The Fig. 1a shows a clear crossover between the in-plane orientation (black arrow and cross-hatched region) and the out-of-plane orientation (white arrow and plain black region). Moreover, this crossover is geometry dependent, and the magnitude of the magnetization is only playing a role in the strength of the magnetostatic energy. The total energy barrier can be expanded considering the magnetostatic energy presented previously and introducing the contribution of the interfacial anisotropy, defined by a surface anisotropy term $k_s$, with a usual value of 1.4mJ/m². With this approach it is possible to maintain a high enough thermal stability factor to sub-10 nm diameters junction. The Fig. 1b shows a thermal stability factor $\Delta$ for a free layer of different aspect ratios with a magnetization saturation of 1 MA/m and a surface anisotropy term $k_s$ of 1.4 mJ/m² for an operation temperature of 300 K. It shows that, by increasing the thickness of the free layer, for a fixed diameter value, it is possible to increase the thermal stability factor $\Delta$. This increase is stronger as the different anisotropy sources are increased, opening different possibilities of engineering this free layer.

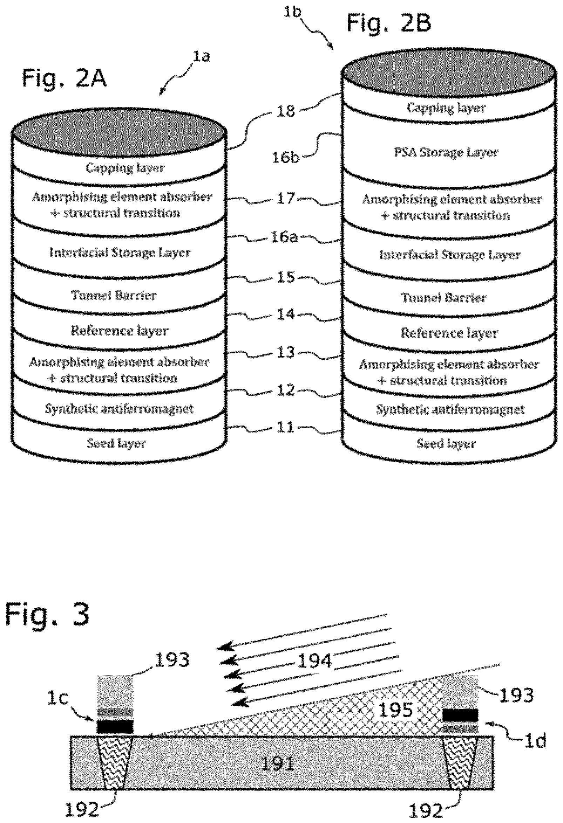

The perpendicular shape-anisotropy (also called "shape anisotropy" or "PSA") provided by the thick free layer is drawing attention due to its scalability and wide temperature operation range. Fig. 2A shows an example of a magnetoresistive devices comprising a perpendicular junction 1a. Fig. 2B shows an example of a magnetoresistive device comprising a shape anisotropy junction 1b (also noted "PSA-MTJ"). In both cases, the devices 1a, 1b are composed of a seed layer 11, a synthetic antiferromagnet 12 followed by a texture breaker 13 and an out-of-plane magnetized reference layer 14. In each magnetic junction 1a, 1b, the reference layer 14 is separated from a thin free layer 16a by a tunnel barrier 15. Each thin free layer 16a exhibits an out-of-plane magnetization due to the interfacial effect between said thin free layer 16a and the tunnel barrier 15 it lies on.

The junction 1b of Fig. 2B differs from the junction 1a of Fig. 2A in that it comprises a ticker free layer 16b staked on top of the thin one 16a, to promote a shape anisotropy that allows for higher stability. This additional layer 16b can be called "perpendicular shape anisotropy layer", "shape anisotropy layer" or "PSA layer", while the thin free layer 16a is called "perpendicular interfacial anisotropy layer" or "interfacial anisotropy layer" or "IA layer".

The Fig. 3 shows a side view of two magnetic stacks 1c, 1d according to the prior art, comprising each a tunnel junction 1c, 1d. The stacks 1c, 1d lean on a substrate 191. Each tunnel junction of the stacks 1c, 1d comprises at least a thick free layer (or shape anisotropy layer) in order to induce perpendicular shape anisotropy. The figure shows a step of the fabrication of the magnetic devices, such as a magnetic storage or a magnetic sensor, comprising tunnel junctions. One of the tunnel junctions (corresponding to the stack 1d) is said "bottom pinned" as the reference layer (and the synthetic antiferromagnet) is located beneath the thick free layer. In other words, the reference layer is located between the tunnel layer and the substrate 191. The other tunnel junction (corresponding to the stack 1c) is said "top pinned" as the reference layer (and the synthetic antiferromagnet) is located above the thick free layer. It means the thick free layer is located between the tunnel barrier and the substrate 191.

At this step of the fabrication flow, each magnetic stack 1c, 1d is yet connected to a metallic layer 192 which will act as a bottom electrode. In the embodiment of the Fig. 3, the metallic layers 192 are metallic vias which cross through the substrate 191 to connect to, for example, an electrical circuit. Each magnetic stack 1c, 1d also comprises, at this step of the fabrication flow, a hard mask 193 on its top part. The hard mask 193 is used in previous steps to etch layers to delimitating the outline of the stacks 1c, 1d and aligning said stacks with respect to the metallic vias 192. The hard mask 193 can also be use in further fabrication steps to produce a final device (such as a memory of a sensor). Due to the thick free layer and the hard mask 193, the magnetic stacks 1c, 1d are relatively tall, for example higher than 200 nm.

They can also show a high aspect ratio (measured as the height by the diameter), for example higher than 15. Therefore, the stacks 1c, 1d tend to fall, tilt or collapse during the following fabrication steps (such as the trimming step describe below). It leads to a large ratio of not properly working tunnel junctions.

In the Fig. 3, a complementary step of trimming the sides of the stacks 1c, 1d is shown. The trimming is performed to further reduce the diameter of the stacks and increase the aspect-ratio of the thick free layer (and improved its shape anisotropy). It allows to get tunnel junctions with a diameter lower than 20 nm, as shown in [N. Perrissin & al., "A highly thermally stable sub-20 nm magnetic random-access memory based on perpendicular shape anisotropy", Nanoscale 10, 12187-12195 (2018)]. The trimming can be performed by exposing the sides of the magnetic stacks 1c, 1d to a grazing ion beam 194. The grazing beam 194 is tilted, witch respect to the surface of the substrate 191, by an angle about 10° to 15°. However, the increased height of the stacks 1c, 1d creates a large shadow area 195 surrounding each stack 1c, 1d, because they are hiding the grazing ion beam 194. No other magnetic stacks 1c, 1d can be made in the shadowed region because it would not be correctly trimmed. It implies a large dot-to-dot distance between neighboring stacks which, which severely degrades the density of the final magnetic devices obtained from the stacks 1c, 1d.

Therefore, there is a need to provide a robust magnetic stack, which can be used in further fabrication steps to produce a magnetoresistive device, and which allows to reduce the dot-to-dot distance between close neighboring stacks.

## SUMMARY

One aspect of the invention concerns a method to fabricate a magnetic device from:

- a conductive electrode, so called "bottom electrode"; and

- a dielectric layer, lying on the bottom electrode and having a through-hole, so called "via", exposing part of the bottom electrode.

The method comprises the steps of:

- forming a tunnel junction stack on the dielectric layer, said formation comprising the sub-steps of:

  - forming a first magnetic layer, intended to form a said "free layer" having a switchable magnetization;

  - forming a second magnetic layer, intended to form a said "reference layer" having a fixed magnetization; and

  - forming an insulator layer, intended to form a "tunnel barrier", separating the first magnetic layer and the second magnetic layer from each other and configured to allow spin transfer torque between the first magnetic layer and the second magnetic layer;

  the first magnetic layer or the second magnetic layer being located in the via and being surrounded by the dielectric layer;
- delimiting the magnetic device from the tunnel junction stack.

Switchable means that the magnetization of the free layer can be switched between distinct orientations, for example reversed between two opposite orientations.
Fixed magnetization means that the orientation of the magnetization of the reference is set and does not switch between distinct orientations.
This method allows to fabrication a magnetic device having a magnetic tunnel junction and electrically connected to the bottom electrode. By making use of the via to deposit a magnetic layer of the junction, the total height of the magnetic device, measured from the dielectric layer, is reduced compared to the device of the prior art (example of Fig. 3). The magnetic layers, and especially the free layer, can exhibit a larger aspect ratio without increasing the height of the magnetic device. The magnetic device has also less chance to tilt or completely fall. Moreover, due to the reduced height, compared to the device according to the prior art, the trimming step induces a narrower shadow region around the device and the dot-to-dot distance between close neighboring devices can be reduced, making it possible to achieve high density integration of magnetic devices.
Using via to fabrication magnetic device is also compatible with complementary metal-oxide-semiconductor fabrication process.
Beneficially, the delimitation step of the magnetic device from the tunnel junction stack comprises the sub-steps of:

- forming a hard mask on the tunnel junction stack, said hard mask being aligned with the via; and

- etching the magnetic device in the tunnel junction stack down to the dielectric layer and in line with the hard mask.

Beneficially, the formation of the tunnel junction stack comprises, before the formation of the first or second magnetic layers, the deposition of a conductive layer, for example made of TaN, on the inner wall of the via.
Beneficially, the deposition of the conductive layer can be also performed on the exposed part of the bottom electrode.
Beneficially, the deposition of the conductive layer on the inner wall of the via is preceded by the deposition of a non-conductive layer, on the inner wall of the via, the conductive layer being deposed on the non-conductive layer.
Beneficially, the layer, among the first magnetic layer or the second magnetic layer, which is located in the via, is formed to reach the top of the via. The top of the via correspond, for example, to the top surface of the dielectric layer.
Beneficially, the first magnetic layer has, after the step of delimiting the magnetic device from the tunnel junction stack, a magnetic anisotropy induced by its shape which makes its magnetization spontaneously pointing out of the plane of the layers. The plane of the layer is, for example, the plane of the top surface of the dielectric layer.

Beneficially, the step of forming the tunnel junction stack comprises a sub-step of forming a third magnetic layer in contact with the insulator layer and having a magnetic anisotropy at its interface with said insulator layer, which makes its magnetization spontaneously pointing out of the plane of the layers.

Beneficially, the method comprises a step of forming a ferromagnetic shell, said formation of the ferromagnetic shell being performed before the formation of the magnetic tunnel junction stack, the ferromagnetic shell being formed against the inner wall of the via and embedded with a non-magnetic material.

A second aspect of the invention concerns a magnetic device comprising:

- a conductive electrode, so called "bottom electrode";

- a dielectric layer, lying on the bottom electrode and having through-hole, so called "via", exposing a part of the bottom electrode; and

- a magnetic tunnel junction comprising:

  - a magnetic free layer having a switchable magnetization;

  - a magnetic reference layer having a fixed magnetization; and

  - a tunnel barrier, separating the free layer and the reference layer from each other and configured to allow spin transfer torque between the free layer and the reference layer;

the free layer or the reference layer being in the via and surrounded by the dielectric layer.

The term "being in the via" means being located in the via.

Beneficially, the device comprises a conductive layer, for example made of TaN, on the inner wall of the via, separating the free layer or the reference layer from the dielectric layer.

The invention and its various applications will be better understood by reading the following description and examining the accompanying figures.

## BRIEF DESCRIPTION OF THE FIGURES

The figures are indicative and in no way limiting of the invention. Unless otherwise specified, the same element appearing in different figures has a unique reference.

The Fig. 1A shows an example of magnetostatic energy of a free layer for several aspect ratios of a magnetic tunnel junction according to the prior art.

The Fig. 1B shows a thermal stability factor for a free layer of different aspect ratios of a magnetic tunnel junction according to the prior art.

The Figs. 2A-B show examples magnetic tunnel junctions according to the prior art.

Figs. 3 shows a side view of a step of trimming the sides of two magnetic stacks according to the prior art.

Fig. 4 shows a first implementation of a method to fabricate a magnetic device according to the invention.

Fig. 5 shows a base device from which the first implementation of the method of Fig. 4 can be carried out.

Figs. 6-7 show an implementation of steps of forming the base device of Fig. 5.

Figs. 8-14 show the first implementation of the method according to the invention to obtain a first embodiment of a magnetic device according to the invention.

Fig. 15 shows a second embodiment of the magnetic device that can be obtain following a second implementation of the method of the invention.

The Figs. 16-21 show a third implementation of the method according to the invention to obtain a third embodiment the magnetic device.

Fig. 22 shows a fourth embodiment of the magnetic device according to the invention.

Fig. 23 shows a fourth implementation of the fabrication according to the invention.

Fig. 24 shows a fifth embodiment of the magnetic device according to the invention.

Fig. 25 shows a fifth implementation of the fabrication according to the invention.

Fig. 26 shows a sixth embodiment of the magnetic device according to the invention.

Figs. 27-31 show computations of the magnetic stray fields.

Figs. 32-39 show a sixth implementation of the fabrication according to the invention to obtain the sixth embodiment of the magnetic device of Fig. 26.

## DETAILED DESCRIPTION

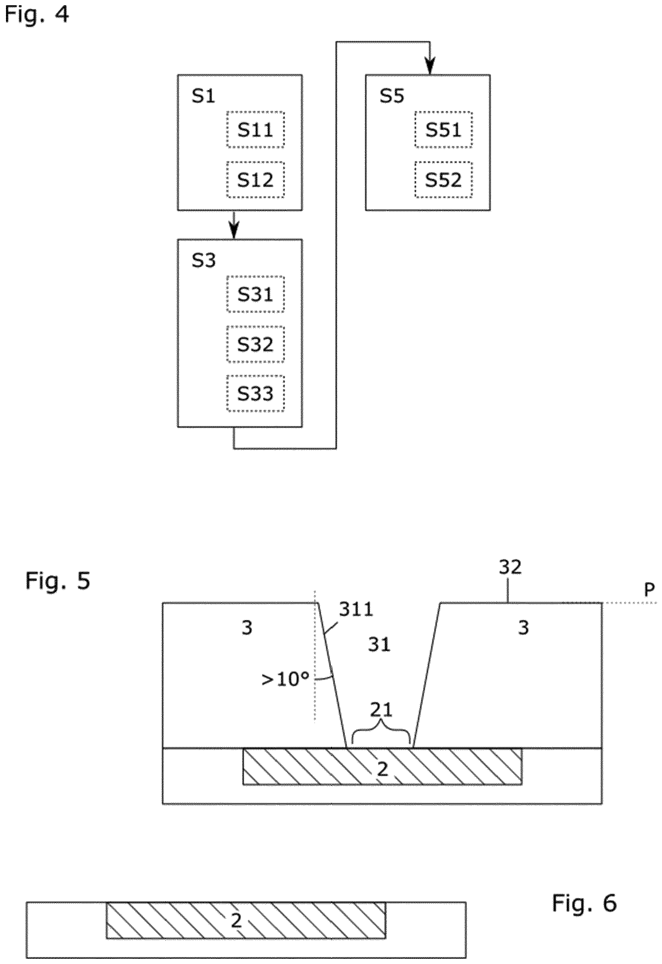

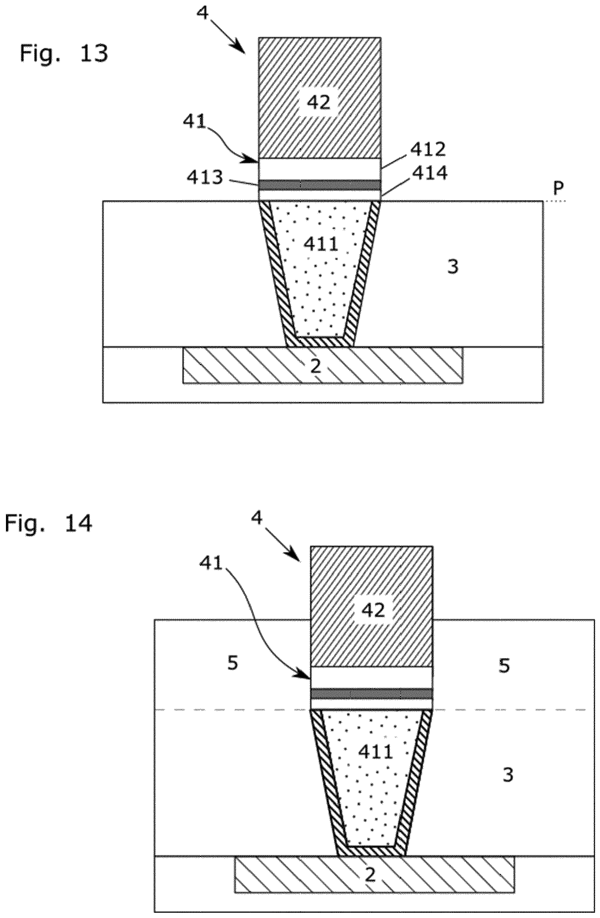

The Figs. 4 shows an implementation of a method to fabricate or produce a magnetic device 4 as illustrated in Figs. 13 to 15. The Figs. 5 to 12 show different steps or sub-steps of the method.

The Fig. 5 shows a base device from which the method can be carried out. The base device comprises a conductive electrode 2 and a dielectric layer 3. The conductive electrode 2 can be called "bottom electrode" as it is intended to be electrically connected to a magnetic tunnel junction 41 of the magnetic device 4. It is also intended to act as an electrode of a final magnetoresistive device (such as a magnetic memory or a magnetic sensor) which can be obtained from the magnetic device 4 (for example after being connected to a top electrode). The bottom electrode 2 can be a metallic line made of, for example, W. It can also be an electrical connection with a circuit or a component (such as a transistor or a selector) lying below the bottom electrode 2. The bottom electrode 2 can be lying on a substrate or in a trench within said substrate (as shown in Fig. 5) such that only its top surface is exposed. It can also be a via filled with a metallic material.

The dielectric layer 3 is lying on the bottom electrode 2. The dielectric layer 3 can embed the bottom electrode 2 (when this one is lying on a substrate) or it can lie on a top surface of the bottom electrode 2 (when the bottom electrode 2 is lying in a trench of a substrate). In the latter case, the dielectric layer 3 can lie on the substrate which embed a part of the bottom electrode 2. The dielectric layer 3 is a non-magnetic and insulator material. It can be made of $SiO_2$ or SiN. It can also be made of a polymer that can withstand chemical and mechanical polishing.

The dielectric layer 3 has a top surface 32 which is, for example, a free surface wherein the fabrication steps will be performed. The top surface 32 can also define a plan P called "plane of the layers".

The dielectric layer 3 comprises a through-hole 31, called "via". The via 31 crosses through the whole dielectric layer 3, from the top surface 32 to the bottom electrode 2. The via 31 exposes a part 21 of the bottom electrode 2, in this case a part 21 of the top surface of the electrode 2. The via 31 can exhibit a straight shape or a truncated flared shape. The via 31 has an inner wall 310, also called side wall. In a straight shape, the inner wall 310 is perpendicular (at +/- 10°) with respect to the plane of the layers P. In a truncated flared shape, as shown in Fig. 1, the inner wall 311 is tilted with respect to the direction perpendicular to the plane of the layers P. It is, for example, tilted with an angle greater or equal to 10°, for example equal 15° or 20°. This particular shape can be provided by the drilling method employed, especially for a via 31 having a diameter lower than 50 nm.

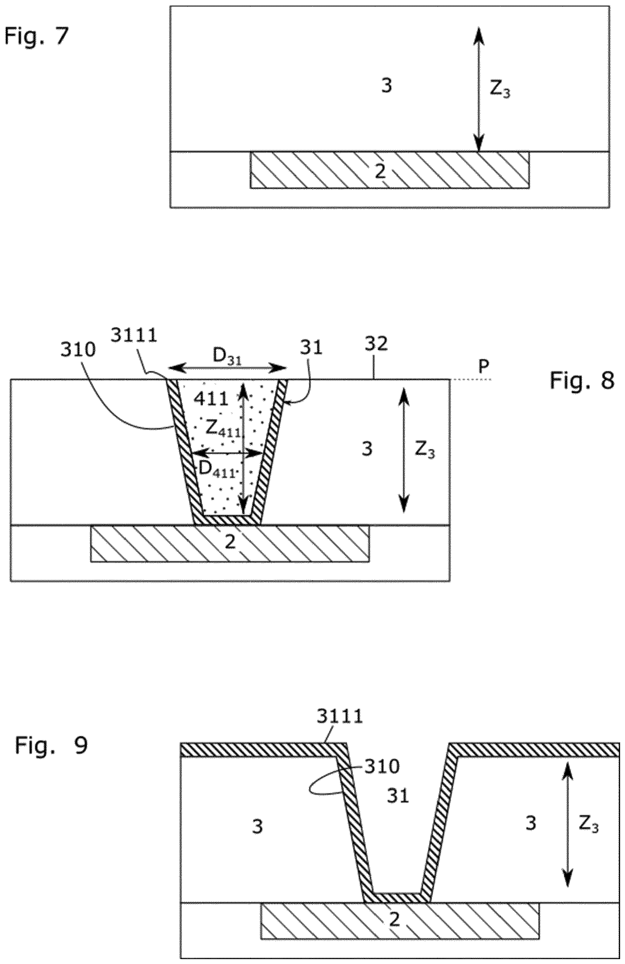

The Figs. 6 and 7 show an implementation of a step of forming S1 the base device shown in Fig. 5. Starting from the bottom electrode 2, located in a trench in a substrate, the formation S1 comprises a sub-step of depositing S11 the dielectric layer 3, for example, using chemical vapor deposition (also called "CVD) or physical vapor deposition (also called "PVD). The depositing can be performed in a blanket manner and a chemical and mechanical polishing (also called "CMP") can be performed to obtain a dielectric layer 3 with a well-controlled thickness $Z_3$ (measured perpendicular to the plane of the layer P). The thickness Z3 of the dielectric layer can be comprised between 10 nm and 100 nm, for example equal to 30 nm.

Following the deposition of the dielectric layer 3, a drilling step S12 can be performed, which results in the through via 31. Implementations of the drilling step S12 can comprise the formation of a sacrificial protruding, before the deposition S11 of the dielectric layer 3, and a specific etching of said sacrificial protruding after it has been revealed by CMP.

The via 31 can also be drilled S12 after the deposition S11 of the dielectric layer 3 using, for example, electron-beam lithography. The drilling step S12 can also rely on self-assembly or any other process which provides organized via 31. The electron-beam lithography usually provides a flared shape or truncated flared shape to the via 31.

The Figs. 8 to 12 shows the step of forming S3, from the base device shown in Fig. 5, a tunnel junction stack 410 on the dielectric layer 3. Said formation step S3 comprises a sub-step forming S31 a first magnetic layer 4110 as shown in the Fig. 8. In this figure, the first magnetic layer 4110 fills the via 31 and reach its top (corresponding to the top surface 32 of the dielectric layer 3). Said magnetic layer 4110 therefore is delimited by the inner wall of the via to form a "free layer" 411 (or "storage layer" if the magnetic device 4 is intended to form a magnetic storage device). Said free layer 411 is remarkable in that it has a magnetization; however, the orientation of the magnetization is not fixed. It can be reversed.

At this stage of the fabrication method, the magnetization of the produced free layer 411 may yet behave freely. The magnetization of the free layer 411 is, however, preferably constraint to align in a predefined direction or at least out of a plane (such as the plane of the layers P). This constraint is obtained by adjusting the anisotropy induced in the free layer 411. For example, the diameter $D_{411}$ and the thickness $Z_{411}$ of the first magnetic layer can be adjust to provide a perpendicular shape anisotropy which makes the magnetization of the layer 411 pointing out of the plan P of the layers. Deposition method to form the free layer 411 may also add some bulk contribution to the anisotropy, such as magneto-crystalline anisotropy. The magnetization is preferably spontaneously pointing out-of-plane if the anisotropy favors it. The magnetization can also be slightly tilted and exhibits a weak in-plane vector due to a weak in-plane shape anisotropy contribution.

The first magnetic layer 411 have a thickness $Z_{411}$, measured perpendicular to the plane of the layers P, which is at most equal to the thickness $Z_3$ of the dielectric layer 3. It can also have a diameter $D_{411}$ which is at most equal to the diameter $D_{31}$ of the via 31. Said diameters $D_{31}$, $D_{411}$ may depending of the height considered in the via 31 (especially when the via has a flared shape).

In the implementation of the Fig. 8, the free layer 411 is formed in the via 31. It is, for example, obtain by depositing the first magnetic layer 4110 by CVD, PVD or electrochemical deposition. The magnetic material used can be Fe, Co, Ni or any alloy thereof. Non-magnetic material can also be added to form magnetic multilayers, such as magnetic/non-magnetic/magnetic multilayers.

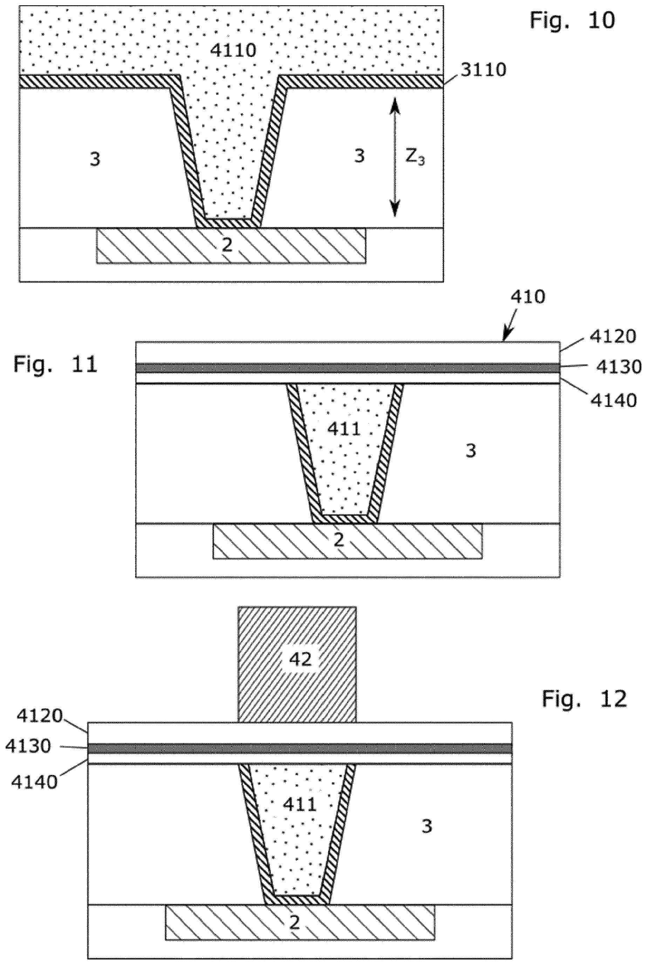

The magnetic material is deposited to fills completely the via 31 and overcome the top of the via 31, as shown in Fig. 10. In other words, the thickness of the magnetic material deposited, measured from the bottom of the via 31, is greater than the thickness Z3 of the via 31.

The Figs. 9 and 10 show an implementation of the sub-step of forming S31 the first magnetic layer 4110. A conductive layer 3111 can be deposited on the inner wall 310 of the via 31 before the first magnetic layer 4110 is deposited. The conductive layer 3111 can be deposited conformally on the inner wall 310 of the via 31. It can be deposited by CVD, PVD or any method that allows conformal deposition, such as atomic layer deposition method (said "ALD") or electroplating.

It can be made of a non-magnetic material, such as TaN. If the conductive layer 3111 is non-magnetic, it reduces the diameter D411 of the resulting free layer 411 (measured parallel to the plane of the layers P). Therefore, it can help to increase the aspect ratio (being the thickness $Z_{411}$ divided by the diameter $D_{411}$) of the free layer 411. The diameter reduction can be controlled by the thickness of the conformally deposited material (measured perpendicular with respect to the surface it is deposited) to form the conductive layer 3111.

If the conductive layer 3111 is magnetic, for example made of Co, the diameter $D_{411}$ of the resulting free magnetic layer 411 is equal to the diameter $D_{31}$ of the via 31. In other words, the resulting free magnetic layer 411 comprises said magnetic conductive layer 3111.

In the implementation of Figs. 4 to 14, the conductive layer 3111 is also deposited on the exposed part 21 of the bottom electrode 2, which lies in the bottom end of the via 31. It can improve the electrical contact with the bottom electrode 2. However, in this case, adjusting the thickness of the conductive layer 3111 may not change the aspect ratio of the resulting free layer 411 as, by reducing the diameter, the height will reduce the same way.

The first magnetic material 4110 can be deposited on the conductive layer 3111, as shown in Fig. 10. It is preferably deposited to fill the via 31, for example in a blanket manner. A CMP can be used to remove the excess of magnetic material and reach the top 32 of the via 31. The CMP can also provide a clean surface without magnetic material lying between neighboring magnetic devices.

CMP which can be performed after the deposition of the first magnetic layer 411 tends to provide small roughness and thus promotes a good texture for the further deposited layers 4140, 4130, 4120. However, CMP may induce a certain degree of dishing of the free layer 411 which might reduce its thickness $Z_{411}$ and especially its magnetic thickness (which may be smaller than the geometric thickness). The thickness $Z_{31}$ of the via 3 and therefore the thickness of the dielectric layer 3 should be adjusted accordingly to balance this dishing effect.

The Fig. 11 shows the two sub-steps of forming S32 a second magnetic layer 4120 and forming S33 an insulator layer 4130 on top of the free layer 411. The second magnetic layer 4120 is intended to form a "reference layer" 412 (which is effectively formed after its delimitation). The reference layer 412 has a magnetization with a fixed orientation.

The insulator layer 4130 is intended to form a "tunnel barrier" 413. For example, the insulator layer 4130 is configured to allow spin transfer torque between the free layer 411 and the second magnetic layer 4120. To do so, the insulator layer 4130 is located between the free layer 411 and second magnetic layers 4120, separating completely those layers. Therefore, in this implementation of the Fig. 11, the sub-step of forming the insulator layer 4130 is performed before the sub-step of forming the reference layer 4120.The insulator layer 4130 can be deposited S33 on the free layer 411, and preferably extend far from the top surface of the free layer 411. It can be deposited in a blanket manner to cover a large area about the free layer 411. It can be deposited by CVD or PVD. It can be made of nitride, such as TiN, or oxide, such as MgO, $Al_2O_3$ or $TiO_2$. The thickness of the insulator layer 413 is preferably comprised between 0.6 nm and 6 nm and more preferably between 1 nm and 2 nm.

Using the thickness of the insulator layer 4130, it is possible to control a product know as RxA product, which is the resistance of the junction 41 times the area of the tunnel barrier 413 obtained from the insulator layer 4130 (after the delimiting step for example). For small diameters magnetic junction 41, the RxA product is chosen lower than 10 $\Omega.\mu m^2$. Therefore, the thickness of the insulator layer 4130 is chosen to provide a sub-10 $\Omega.\mu m^2$ RxA product of the junction 41.

To achieve high tunnel magnetic response (so called "TMR"), for example around 200%, the magnetic device 4 can comprise a ferromagnetic layer 414 so-called "interfacial magnetic layer", which can promote a specific crystallographic structure to the tunnel barrier 413, such as a body centered-cubic with a (100) texture. The interfacial magnetic layer 414 is, for example, on one side, in direct contact with the reference layer 412, and on the other side, in direct contact with the interfacial magnetic layer 414.

The interfacial layer 414 can be made of a FeCo alloy or FeCo(B) alloy which is amorphous as deposited. However, said interfacial layer 414 414 can crystallize in a body centered-cubic with a (100) texture upon annealing at a temperature usually ranging from between 250° to 400°C. The crystallization of the interfacial layer 414 tends to force a crystallization of the tunnel barrier 413 following the same structure.. The annealing can be performed after the device 4 fabrication or at least before the hard-mask deposition.

The interfacial layer 414 is shown by the Fig. 13. The Figs. 11 and 12 shows a way to form the interfacial layer 414. For example, a third magnetic layer 4140, intended to form the interfacial layer 414, can be deposited in a way to be in direct contact with the insulator layer 4130. The third magnetic layer 4140 can be deposited on the free layer 414 first and the insulator barrier 4130 can then be deposited. The insulator layer 4130 is thus separating the third magnetic layer 4140 and the second magnetic layer 4120.

When the tunnel barrier 413 is made of MgO, the interfacial layer 414 can also induce an interfacial anisotropy at its interface with said tunnel barrier 413. Especially when the interfacial layer 414 is made of FeCo or FeCo(B).

The free layer 411 and the interfacial layer 414 can be directly stacked, one on the other, to promote a strong coupling between their respective magnetizations. It ensures a resulting magnetization behaving as a unique and rigid magnetization (also called "macrospin"). However, the free layer 411 and the interfacial layer 414 can also be separated by a thin layer which adapt the crystallographic structures of the magnetic layers 411n 414. However, the thickness is preferably chosen to keep a macrospin behavior of the resulting magnetization.

The crystallization of the interfacial layer 414 and the tunnel barrier can be help by when amorphising elements are removed from the interface between the interfacial layer 414 and the tunnel barrier 413. To do so, a structural transition layer (also known as "amorphising-getter layer" or "B-getter layer" because it tends to trap B element from magnetic layers which is a common amorphising element) can be insert between the free layer 411 and the interfacial layer 414 went the latter comprise amorphising element such as B. For example, the interfacial layer 414 can be made of FeCo(B). In this case, the B-getter layer is located between the free layer 411 and the interfacial layer 414. The B-getter layer is at least in direct contact with said magnetic layer made of FeCo(B). The B-getter layer can be made of W, Ta, Mo or Hf. It has preferably a thickness comprised between 0.1 nm and 0.3 nm.

The second magnetic layer 4120 is deposited S32 on top of the insulator layer 4130, by CVD, PVD.

The Figs. 12 and 13 show a step of delimiting S5 the magnetic device 4 from the tunnel junction stack 410. This step comprises, for example, a sub-step of forming S51 a hard mask 42 on the tunnel junction stack 410, as shown in Fig. 12, and sub-step of etching S52 the tunnel junction stack 410 not hidden by the hard mask 42 down to the dielectric layer 3.

The hard mask 42 can be a metallic protruding formed on top of the tunnel junction stack 410. It can be made of SiN, Ta, TaN or any other conductive material that can withstand ion-etching. Its shape induces the shape of the pillar in line with said hard mask 42, resulting from the etching of the material not hidden under the hard mask 42. Therefore, the hard mask is preferably aligned with free layer 411 and therefore with the via 31. The remaining material of the tunnel junction stack 410 and the free layer 411 form a tunnel junction 41.

The etching S52 can be performed using a reactive ion-etching method and preferably along a perpendicular direction (also said "vertical direction") with respect to the plane of the layers P. The etching is preferably performed until it reaches the top surface 32 of the dielectric layer 3. Redeposition of etched material can occur, therefore, a trimming of the side of the part of the magnetic device 4 that comes out the dielectric layer 3. Said trimming can be performed using ion-beam trimming at a grazing angle.

The hard mask 41 is preferably a conductive layer so it can be connected to a conductive electrode such as a top electrode.

The Fig. 14 shows a further fabrication step wherein a complementary dielectric material 5 is deposited so that it surrounds the part of the magnetic device 4 that comes out the dielectric layer 3. It ensures that no direct electrical connection between the conductive layers occurs. The complementary dielectric material 5 can be made of SiN or a polymer. It can also be made of the same material forming the dielectric layer 3 having the via 31 if said same material allows for planarization.

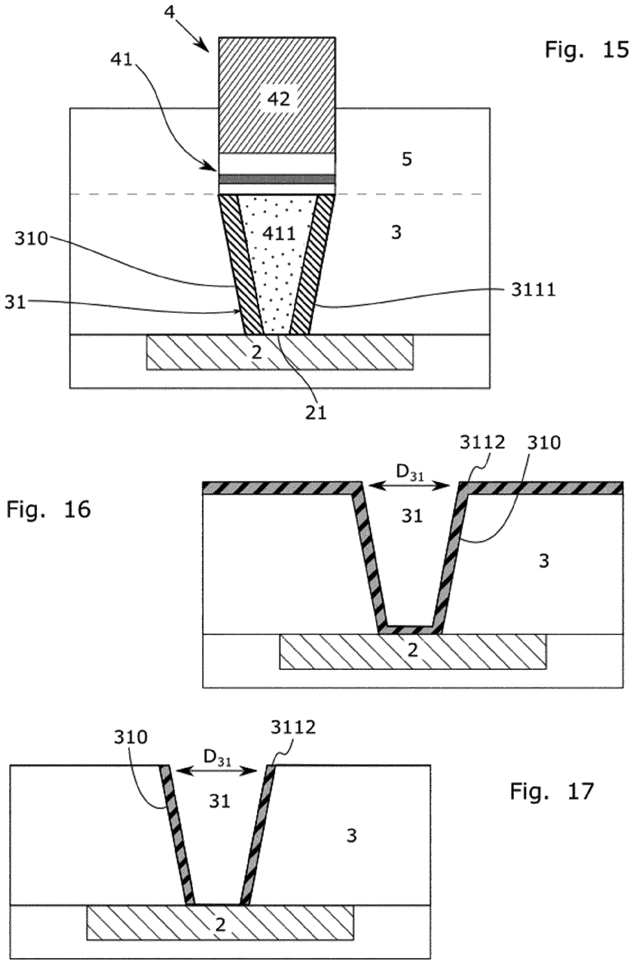

The Fig. 15 show another embodiment of the magnetic device 4 that can be obtain following another implementation of the method of the invention. This implementation differs from the previous one in that the conductive layer 3111 is only deposited conformally on the inner wall 310 of the via 31. The exposed part 21 of the bottom electrode is free from conductive layer 3111. The free layer 411 is therefore in direct contact with the bottom electrode 2. Moreover, the conductive layer 3111 on the inner wall 310 has been deposited with a larger thickness, measured perpendicularly to the inner wall 310. It further reduces the diameter $D_{411}$ of the free layer 411 and increases its aspect ratio ($Z411/D411$).

To induce the perpendicular anisotropy, the free layer 411 can have a magnetic anisotropy induced by its shape. The free layer is, for example, made of Fe, Ni or Co or any alloy thereof. Its diameter can be limited by the diameter $D_{31}$ of the via 31. Therefore, it can have a thickness such that is exhibits as aspect ratio which tend to orient spontaneously its magnetization out of the plane of the layers P. The aspect ratio of the first sublayer is, for example, greater than 0.5 and preferably comprised between 0.7 and 1.5.

The Figs. 16 to 21 show another implementation of the method to fabricate or produce the magnetic device 4. The steps illustrated by the Figs. 16 to 18 differs from the two previous implementations in that the deposition of a conductive layer 3111 on the inner wall 310 of the via 31 is preceded by a deposition of a non-conductive layer 3112 on the inner wall of the via 31. The conductive layer 3111 is then deposed on the non-conductive layer 3112.

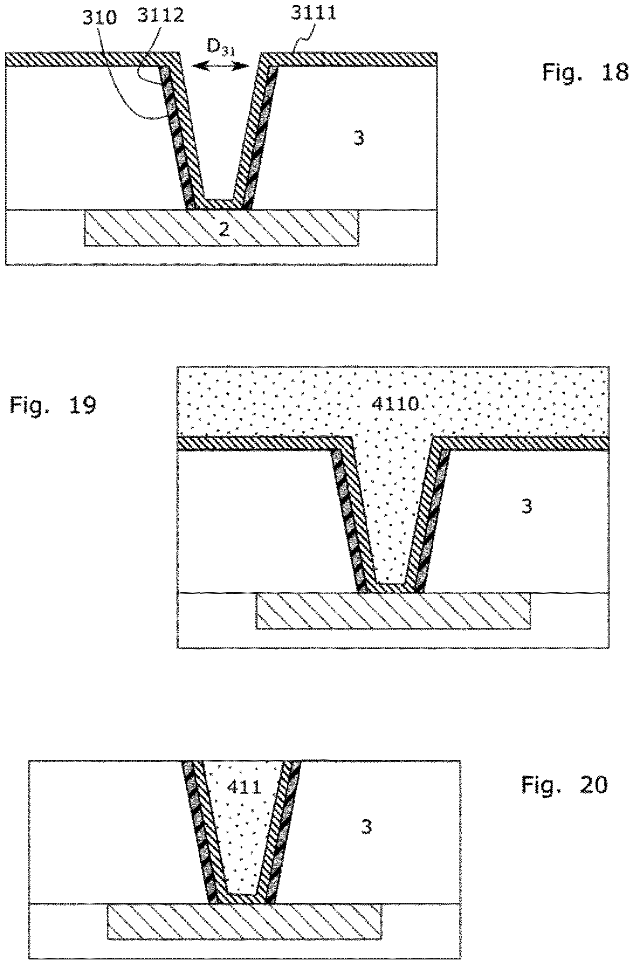

The non-conductive layer 3112 is, for example, deposited conformally by CVD, PVD, ALD or electroplating (resulting in the conformal layer shown in Fig. 16). It is preferable that the non-conductive material 3112 at the bottom end of the via 31 is removed in order to allow a good electrical contact with the bottom electrode 2. To do so, the non-conductive material 3112 can be submit to a vertical etching to remove its parts parallel to the plane of the layers P, especially its part at the bottom end of the via 31 (as shown in Fig. 17). The conductive layer 3111 is then deposited conformally on the non-conductive layer 3111 (as shown in Fig. 18).

The non-conductive layer 3112 reduces further the diameter $D_{31}$ of the via which can help to decrease the diameter $D_{411}$ of the free layer 411 and increase its aspect ratio. The diameter reduction is related to the thickness (measured perpendicular to the surface it rests on) of the non-conductive layer 3112. The thickness of the conformal layer of non-conductive material (and therefore the diameter reduction) is mainly controlled by the conformal deposition process used and even it can also be controlled by the vertical etching used to remove the bottom parts.

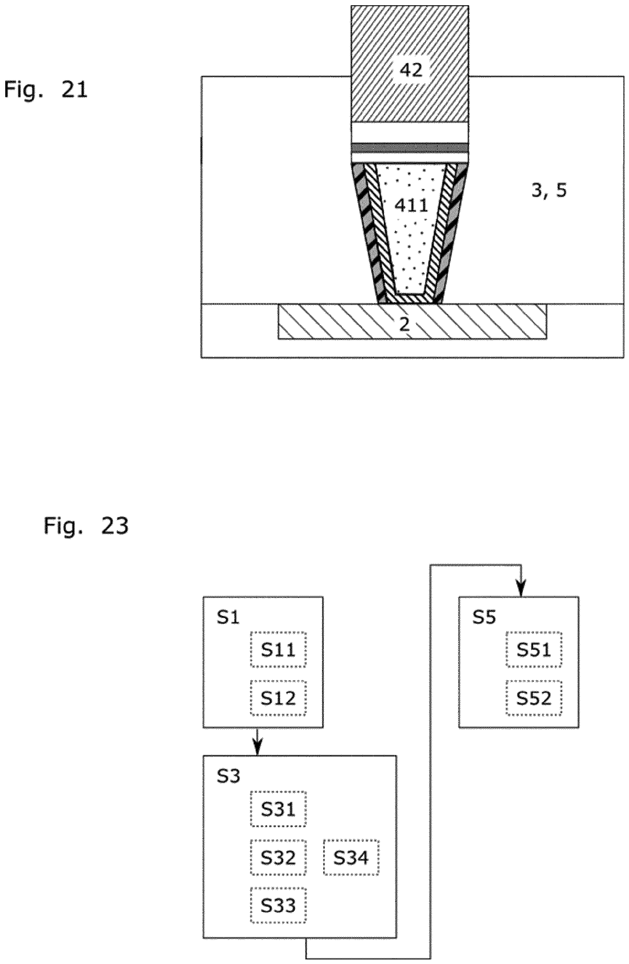

After the formation of the non-conductive layer 3112, the first magnetic layer 4110 can then be formed as previously described, on the conductive layer 3111, as shown in Figs. 19 to 20. The magnetic device 4 produced and shown in Fig. 21 differs from the one of Fig. 14 in that the free layer 411 is narrower and therefore can exhibits a larger aspect ratio (and a higher shape anisotropy).

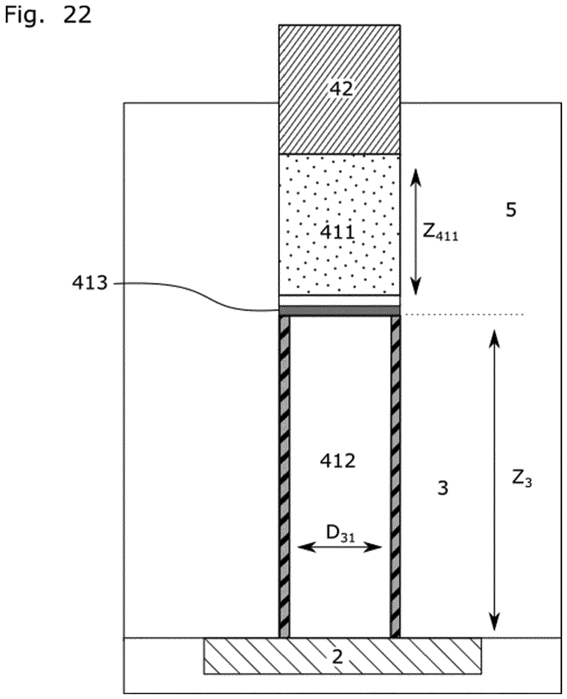

The Fig. 22 show an embodiment of the magnetic device 4 that can be obtain following another implementation of the method. This implementation differs from the previous ones in that the second magnetic layer 4120 is formed first and fills the via 31. Therefore, the via 31 delimits the reference layer 412 which is thus located in the via 31 (instead of the free layer 411). The reference layer 412 is surrounded by the dielectric layer 3. The magnetic device 4 is said "bottom pined" as the reference layer 412 is located beneath the free layer 411.

The magnetization of the resulting reference layer 412 should exhibit a fixed orientation. To do so, the thickness of the dielectric layer 3 can be larger than the ones of the previous embodiments. The high aspect ratio of the resulting reference layer 412 (computed as $Z_3/D_{31}$) will induce a strong shape anisotropy which can pin the magnetization of the reference layer 412 in a fixed direction, perpendicular to the plane of the layers P. The aspect ratio of the reference layer 412 is preferably dimensioned so that the magnetization of the free layer 411 would flip before the magnetization of the reference layer 412. The aspect ratio of the reference layer 412 is, for example, higher than the aspect ratio of the free layer 411. If the free layer 411 and reference layer 412 exhibit the same diameters, therefore the thickness $Z_3$ of the dielectric layer 3 should be much larger than the thickness $Z_{411}$ of the first magnetic layer 411. For example, the reference layer 412 can made of Co. It can also exhibit an aspect ratio (computed as $Z_3/D_{31}$) comprised between 0.8 and 3.

To reduce the thickness $Z_3$ of the dielectric layer 3, the third magnetic materiel 4140 can be deposited between the second magnetic layer 4120 and the insulator layer 4130. It can induce an interfacial anisotropy (with respect to the plane of the layers P), which can reinforce a total anisotropy of the interfacial and reference layer layers 414, 412. For example, the interfacial layer 414 can be made of a Fe alloy, such as FeCo or FeCo(B), and in a direct contact with the tunnel barrier 413 when it is made of MgO. The interfacial anisotropy can help to reduce the constraint on the aspect ratio of the second magnetic layer 412 and therefore and help to reduce the thickness of the dielectric layer 3.

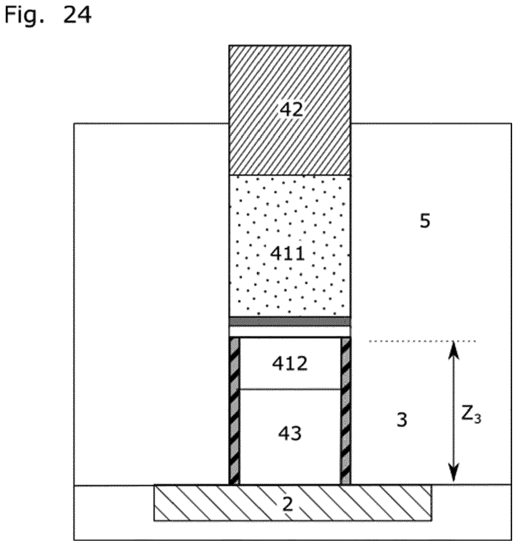

The Fig. 23 shows another implementation of the fabrication method which help to reduce even further the thickness $Z_3$ of the dielectric layer 3, as shown in the embodiment of the Fig. 24. In this embodiment, the reference layer 412 is strongly coupled with a synthetic antiferromagnet 43. The synthetic antiferromagnet 43 is, for example, located in the via 31 as well as the reference layer 412. It is, for example, located between the reference layer 412 and the bottom electrode 2. The synthetic antiferromagnet 43 can comprise two multilayers of [Co/Pt]n (where n is the number Co/Pt layers) coupled by exchange, thanks to a Ru layer. The synthetic antiferromagnet 43 can also be coupled to the reference layer 412 thanks to a Ru layer.

The implementation of the method of Fig. 23 comprises a sub-step of forming S34, when the reference layer 412 is intended to be located in the via 31, the synthetic antiferromagnet 43 in the via 31, before the sub-step S32 of forming the second magnetic layer 4120. The synthetic antiferromagnet 43, when being a multilayer of [Co/Pt]n, can be deposited using electrodeposition.

The embodiment of Fig. 22 exhibits a larger thickness $Z_3$ of the dielectric layer 3. However, the reference layer 412 does not rely on a synthetic antiferromagnet 43. Therefore, it allows to diverge from the use of scarce materials, such as Co, Pt or Pd.

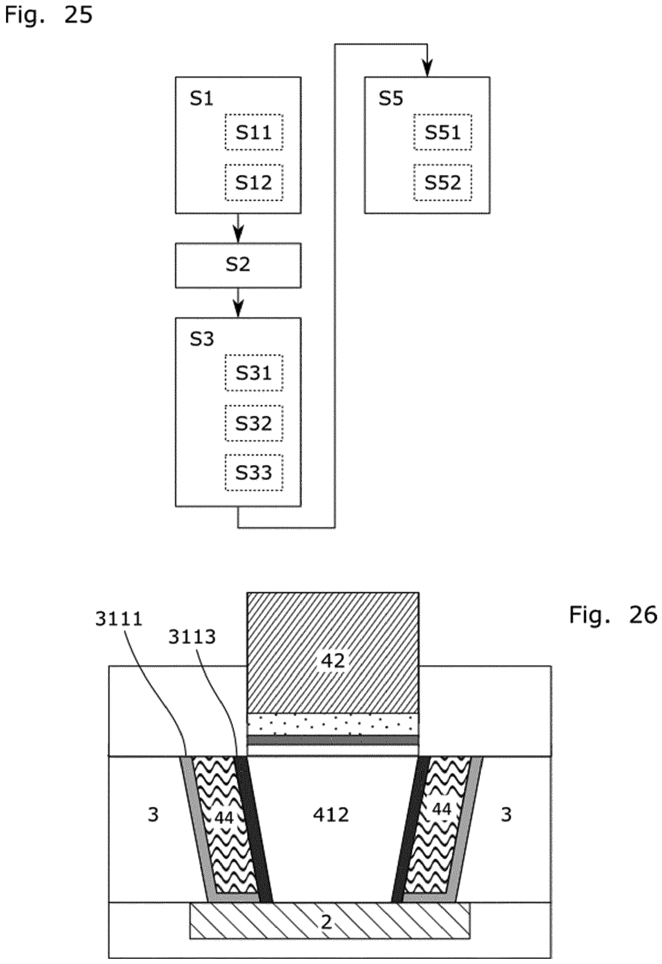

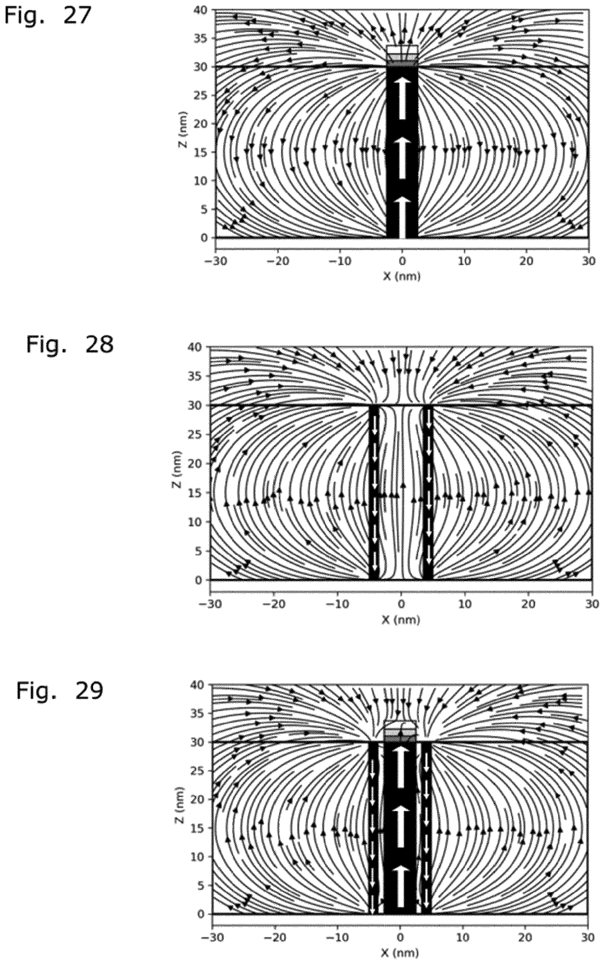

Another implementation of the fabrication method, shown by Fig. 25, allows to form the magnetic device 4 according to the embodiment of Fig. 26, wherein the magnetic field stray by the reference layer 412 is reduced, as shown in Figs. 27 to 31.

In the embodiment of Fig. 26, a ferromagnetic shell 44 is surrounding the reference layer 412, which is located in the via 31. In order to reduce the stray field, the ferromagnetic shell 44 is antiferromagnetically coupled with the refence layer 412. To do so, the ferromagnetic shell 44 and the refence layer 412 are separated from each other by a non-magnetic layer 3113, also called "spacer". The non-magnetic spacer 3113 can be an insulator or a metallic layer. When the non-magnetic spacer 3113 is an insulator, the coupling between the reference layer 412 and the ferromagnetic shell 44 is purely magnetostatic. When the non-magnetic spacer 3113 is metallic, and especially in Ru, the coupling between the reference layer 412 and the ferromagnetic shell 44 can be an exchange coupling and a magnetostatic coupling. The thickness of the non-magnetic spacer 3113 (measured perpendicular to the surface it rests on) can define the strength of the coupling and/or the nature of the coupling (i.e. ferromagnetic coupling wherein the magnetizations of the reference layer 412 and the shell 44 are parallel, or antiferromagnetic coupling wherein said magnetizations are antiparallel). The thickness is therefore chosen so an antiferromagnetic coupling is obtained between the magnetizations of the ferromagnetic shell 44 and the reference 412.

To balance the stray field of the reference layer 412, the ferromagnetic shell 44 should exhibits a magnetic volume (defined as the volume of its magnetic material times the saturation magnetization of said magnetic material) as close as possible to the magnetic volume of the reference layer 412, or at least comprised between 50 % to 150 % of the magnetic volume of the reference layer 412. For example, the thickness and/or width of the ferromagnetic shell 44 can be chosen so its magnetic volume is comprised between 50 % to 150 % of the magnetic volume of the reference layer 412.

The field compensation is also better if the ferromagnetic shell 44 surrounds the reference layer 412 in the via 31 on a large part of the thickness of said layer 412. The thickness of the ferromagnetic shell 44 is for example equal to the thickness of the reference layer 412. It can, for example, be equal to the thickness $Z_3$ of the dielectric layer 3.

In an alternate embodiment, the free layer 411 can be lying in the via 31 instead of the reference layer 412, and the ferromagnetic shell 44 is thus compensating the stray field of the free layer 411 instead.

The Figs. 27 to 31 show the stray field lines computed of a high aspect-ratio reference layer 412 (such as shown in Fig. 22) with and without the ferromagnetic shell 44 (magnetizations shown with white arrows). The stray field is shown for reference layer 412 alone in Fig. 27, for the ferromagnetic shell 44 alone in Fig. 28, and for said reference layer 412 surrounded by said ferromagnetic shell 44 in Fig. 29. The stray field lines, in Fig. 29, created by the shell 44 and the reference layer 412 are shown with opposite directions, which allow a mitigation of the total stray field.

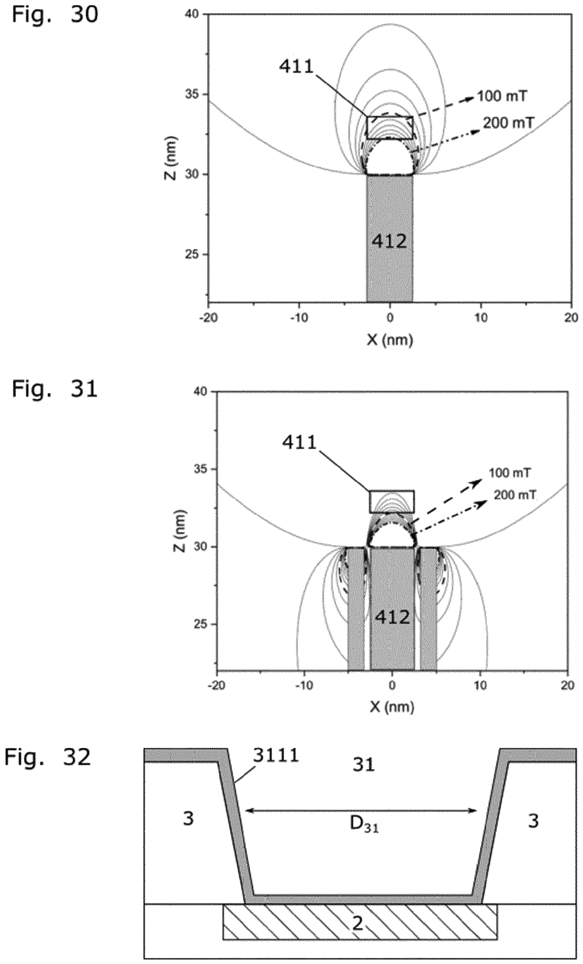

The Figs. 30 and 31 show the difference in field offset that would be produced in the free layer 411 (black square in line with the reference layer 412) by the unshelled reference layer 412 (Fig. 30) and by the shelled reference layer 412 (Fig. 31). In this example, the reference layer 412 has a 30 nm thickness and a 5 nm diameter with a magnetization saturation of 1 MA/m. The reference layer 412 is Pt/Pd free and has a fixed magnetization thanks to its shape anisotropy due to its high aspect ratio. The ferromagnetic shell 44 is spaced 1 nm from the reference layer 412 and has a total width of 10 nm with a magnetization saturation of 1.446 MA/m. These two objects act as a single object as they are dipolar coupled as thus the stability will be further increased. 100 mT and 200 mT iso-fields are also shown. It can be observed a complete mitigation of the stray field by making use of the ferromagnetic shell 44. The stray field from the shelled reference layer 412 is less than 100 mT at the free layer 411. This results also proves that a Pt free or Pd free magnetic tunnel junction can exhibits a low stray field thanks to the ferromagnetic shell 44 and therefore allows for further high-density integration.

The Figs. 32 to 38 show steps of another implementation of the fabrication method to obtain the embodiment of the magnetic device 4 of Fig. 26.

First, the via 31 is preferably wider in order to allow enough space to form the ferromagnetic shell 44 in it. The diameter of the via 31 is for example 20 nm or even wider. A conformal deposition of a dielectric material 3111 can be realized (shown in Fig. 32) taking advantage of chemical-based techniques, such as PVD, CVD, ALD or electroplating. The conformal deposition of the dielectric material 3111 is performed with a thickness (measured perpendicularly to the surface 311 it rests on) that will enable a controlled diameter of the ferromagnetic shell 44 and the magnetic layer 411, 412 surrounded by the shell 44.

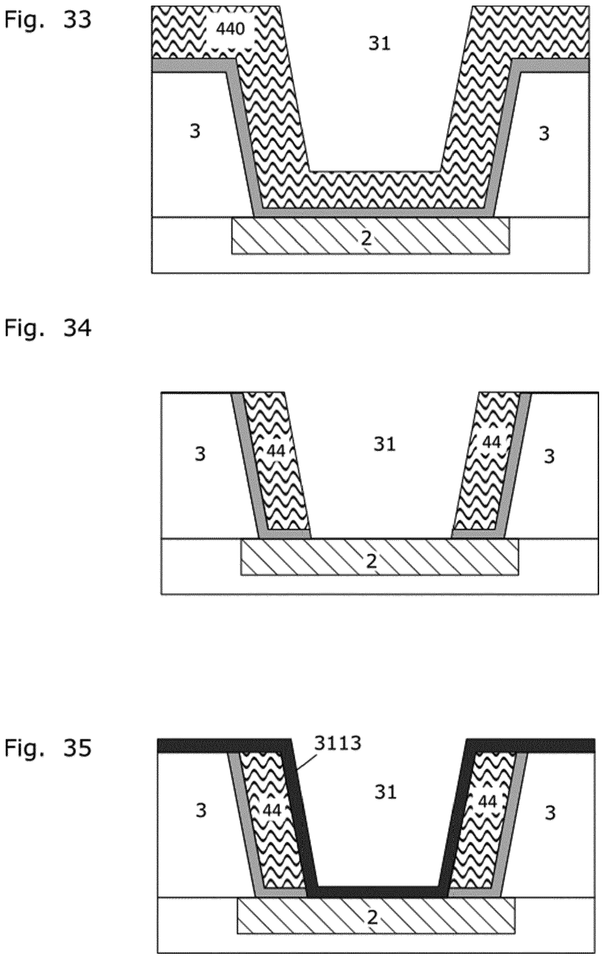

A conformal deposition of a ferromagnetic layer 440 is realized (shown in Fig. 33). The ferromagnetic material can be conductive or non-conductive. It can also take advantage of the chemical-based techniques mentioned above. The thickness of this layer 440 is chosen to optimize the stray field mitigation. The ferromagnetic material used is, for example, Ni or Fe or any allow thereof, such as $Ni_{20}Fe_{80}$ or $Ni_{80}Fe_{20}$.

A vertical etching is realized to remove the parts of the ferromagnetic layer 440 and the dielectric layer 3111 at the bottom end of the via 31 (shown in Fig. 34). It exposes the bottom electrode 2 to be contacted by the tunnel junction 41. It also forms the ferromagnetic shell 44, having, for example, a cylindrical shape.

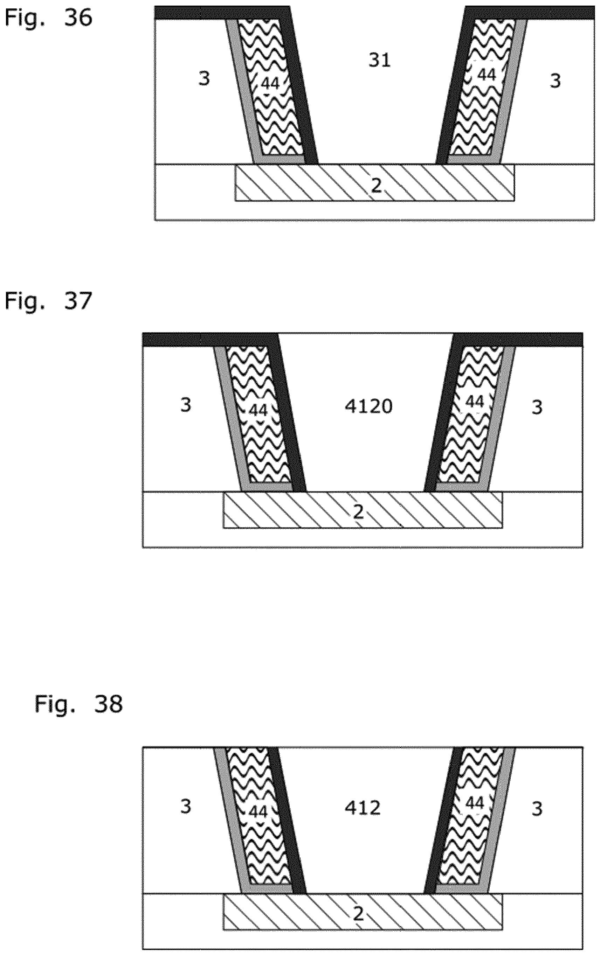

The non-magnetic spacer 3113 is deposited conformally on the ferromagnetic shell 44 (Fig. 35). The spacer 3113 may be an insulator material such as ZnO, $HfO_2$, $Al_2O_3$ or TiN. It can also be a metallic material allowing for exchange coupling between the shell 44 and the layer intended to be in the via 31. The metallic material is, for example, Ru. In case the non-magnetic spacer 3113 is an insulator, a vertical etching is preferably realized (Fig. 36) to expose the bottom electrode 2 and allow a good electrical contact.

The thickness of the non-magnetic spacer 3113 allows to control the coupling strength between the shell 44 and the magnetic layer 411, 412 in the via 31. It also allows to control the diameter reduction in the via 31, which can increase the aspect ratio of the magnetic layer 411, 412 in the via 31.

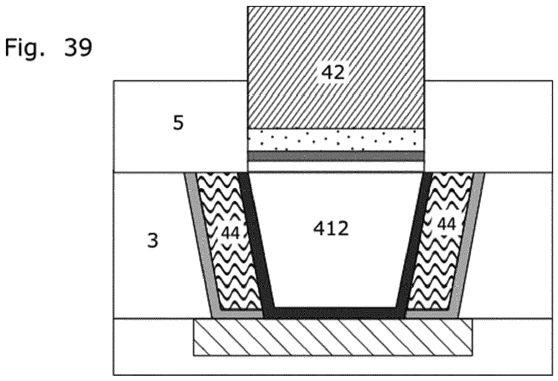

In the example of Fig. 37, the second magnetic layer 4120 is deposited to fill the remaining empty space in the via 31. A chemical and mechanical polishing (Fig. 38) is then realized to form the reference layer 412 and allow further formations of the remaining layers of the magnetic device 4 (Fig. 39).

In case the non-magnetic spacer 3113 is metallic, no vertical etching is required and the reference layer 412 can be deposited in the remaining space of the via 31, as shown in Fig. 39. In this figure, the metallic spacer 3113 is conductive and allows an electrical connection between the bottom electrode 2 and the reference layer 412.

## Claims

1.    Method to fabricate a magnetic device (4) from:

- a conductive electrode (2), so called "bottom electrode"; and
- a dielectric layer (3), lying on the bottom electrode and having a through-hole (31), so called "via", exposing a part (21) of the bottom electrode (2),

the method comprising the steps of:

- forming (S3) a tunnel junction stack (410) on the dielectric layer (3), said formation comprising the sub-steps of:

- forming (S31) a first magnetic layer (4110), intended to form a said "free layer" (411) having a switchable magnetization;
- forming (S32) a second magnetic layer (4120), intended to form a said "reference layer" (412) having a fixed magnetization; and
- forming (S33) an insulator layer (4130), intended to form a "tunnel barrier" (413), separating the first magnetic layer (4110) and the second magnetic layer (4120) from each other and configured to allow spin transfer torque between the first magnetic layer (4110) and the second magnetic layer (4120);

the first magnetic layer (4110) or the second magnetic layer (4120) being located in the via (31) and being surrounded by the dielectric layer (3);
- delimiting (S5) the magnetic device (4) from the tunnel junction stack (410).

2.    Method according to the previous claim, wherein said delimitation of the magnetic device (4) from the tunnel junction stack (410) comprises the subs-steps of:

- forming (S51) a hard mask (42) on the tunnel junction stack (410), said hard mask (42) being aligned with the via (31); and

- etching (S52) the magnetic device (4) in the tunnel junction stack (410) down to the dielectric layer (3) and in line with the hard mask (42).

3. Method according to any of the previous claims, wherein the formation (S3) of the tunnel junction stack (41) comprises, before the formation of the first or second magnetic layers (4110, 4120), the deposition of a conductive layer (3110) on the inner wall (310) of the via (31).

4. Method according to the previous claim, the deposition of the conductive layer (3111) is also performed on the exposed part (21) of the bottom electrode (2).

5. Method according to any of the two previous claims, wherein the deposition of the conductive layer (3111) on the inner wall (310) of the via (31) is preceded by the deposition of a non-conductive layer (3112) on the inner wall (310) of the via (31), the conductive layer (3111) being deposed on the non-conductive layer (3112).

6. Method according to any of the previous claims, wherein the layer, among the first magnetic layer (4110) or the second magnetic layer (4120), which is located in the via (31), is formed to reach the top (32) of the via (31).

7. Method according to any of the previous claims, wherein the first magnetic layer (4110) has, after the step of delimiting the magnetic device from the tunnel junction stack, a magnetic anisotropy induced by its shape which makes its magnetization spontaneously pointing out of the plane of the layers (P).

8. Method according to any of the previous claims, wherein the step of forming the tunnel junction stack comprises a sub-step of forming a third magnetic layer (4140) in contact with the insulator layer (4130) and having a magnetic anisotropy at its interface with said insulator layer (4130) which makes its magnetization spontaneously pointing out of the plane of the layers (P).

9. Method according to any of the previous claims, comprising a step of forming (S2) a ferromagnetic shell (44), said formation (S2) of the ferromagnetic shell being performed before the formation (S3) of the tunnel junction stack (41), the ferromagnetic shell being formed against the inner wall (311) of the via (31) and embedded with a non-magnetic material.

10. Magnetic device (4) comprising:

   - a conductive electrode (2), so called "bottom electrode";
   - a dielectric layer (3), lying on the bottom electrode and having through-hole (31), so called "via", exposing a part (21) of the bottom electrode (2); and
   - a magnetic tunnel junction (41) comprising:

      - a magnetic free layer (411) having a switchable magnetization;
      - a magnetic reference layer (412) having a fixed magnetization; and
      - a tunnel barrier (413), separating the free layer (411) and the reference layer (412) from each other and configured to allow spin transfer torque between the free layer (411) and the reference layer (412);

   the free layer (411) or the reference layer (412) being in the via (31) and is surrounded by the dielectric layer (3).

11. Magnetic device (4) according to the previous claim, comprising a conductive layer (3111) on the inner wall of the via (31), separating the free layer (411) or the reference layer (412) from the dielectric layer (3).

## Fig. 1A

## Fig. 1B

Fig. 2A

1a

Fig. 2B

1b

| Fig. 2A (1a) | | Fig. 2B (1b) |
|---|---|---|
| Capping layer | 18 | Capping layer |
| | 16b | PSA Storage Layer |
| Amorphising element absorber + structural transition | 17 | Amorphising element absorber + structural transition |
| Interfacial Storage Layer | 16a | Interfacial Storage Layer |
| Tunnel Barrier | 15 | Tunnel Barrier |
| Reference layer | 14 | Reference layer |
| Amorphising element absorber + structural transition | 13 | Amorphising element absorber + structural transition |
| Synthetic antiferromagnet | 12 | Synthetic antiferromagnet |
| Seed layer | 11 | Seed layer |

Fig. 3

193
194
1c
193
195
1d
191
192
192

Fig. 4

```
┌─────────────────┐              ┌─────────────────┐
│ S1              │              │ S5              │
│                 │              │                 │
│   ┌ ─ ─ ─ ─ ┐   │              │   ┌ ─ ─ ─ ─ ┐   │
│   │  S11    │   │              │   │  S51    │   │
│   └ ─ ─ ─ ─ ┘   │              │   └ ─ ─ ─ ─ ┘   │
│                 │              │                 │
│   ┌ ─ ─ ─ ─ ┐   │              │   ┌ ─ ─ ─ ─ ┐   │
│   │  S12    │   │              │   │  S52    │   │
│   └ ─ ─ ─ ─ ┘   │              │   └ ─ ─ ─ ─ ┘   │
└────────┬────────┘              └─────────────────┘
         │
         ▼
┌─────────────────┐
│ S3              │
│                 │
│   ┌ ─ ─ ─ ─ ┐   │
│   │  S31    │   │
│   └ ─ ─ ─ ─ ┘   │
│                 │
│   ┌ ─ ─ ─ ─ ┐   │
│   │  S32    │   │
│   └ ─ ─ ─ ─ ┘   │
│                 │
│   ┌ ─ ─ ─ ─ ┐   │
│   │  S33    │   │
│   └ ─ ─ ─ ─ ┘   │
└─────────────────┘
```

Fig. 5

Fig. 6

Fig. 7

Fig. 8

Fig. 9

Fig. 10

4110

3110

3

3    Z₃

2

410

4120
4130
4140

Fig. 11

411

3

2

42

Fig. 12

4120
4130
4140

411

3

2

Fig. 13

Fig. 14

Fig. 15

Fig. 16

Fig. 17

Fig. 18

Fig. 19

Fig. 20

Fig. 21

42

3, 5

411

2

Fig. 23

S1

S11

S12

S3

S31

S32    S34

S33

S5

S51

S52

Fig. 22

Fig. 24

Fig. 25

Fig. 26

Fig. 27

Fig. 28

Fig. 29

Fig. 30

Fig. 31

Fig. 32

Fig. 33

440 31

3 3

2

Fig. 34

3 44 31 44 3

2

Fig. 35

3113

3 44 31 44 3

2

Fig. 36

Fig. 37

Fig. 38

Fig. 39

Europäisches
Patentamt

European
Patent Office

Office européen
des brevets

# EUROPEAN SEARCH REPORT

Application Number

EP 22 20 4792

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/108706 A1 (MAHAJAN SUNIT S [US]) 19 April 2018 (2018-04-19) | 1-4,6,7, 10,11 | INV. H10B61/00 H10N50/01 H10N50/10 |
| A | * paragraph [0013] – paragraph [0030]; figures 1-5 * | 5 | |
| A | TW 201 133 757 A (SAMSUNG ELECTRONICS CO LTD [KR]) 1 October 2011 (2011-10-01) * figures 18-20 * | 5 | |
| A | US 2022/263013 A1 (CHEN JUN-YAO [TW] ET AL) 18 August 2022 (2022-08-18) * paragraph [0018] – paragraph [0030]; figures 1,2 * | 5 | |

|  |
|---|
| TECHNICAL FIELDS SEARCHED (IPC) |
| H10B H10N |

The present search report has been drawn up for all claims

| Place of search | Date of completion of the search | Examiner |
|---|---|---|
| Munich | 30 March 2023 | Gröger, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................
& : member of the same patent family, corresponding document

EPO FORM 1503 03.82 (P04C01)

Europäisches
Patentamt

European
Patent Office

Office européen
des brevets

Application Number

EP 22 20 4792

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

**see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

**1-7, 10, 11**

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 22 20 4792

The Search Division considers that the present European patent application does not comply with the requirements of unity of invention and relates to several inventions or groups of inventions, namely:

1. claims: 1-7, 10, 11

   A combination of an electrically conductive liner on an electrically insulating liner – cf. claim 5 – results in an increased aspect ratio and, thereby, enhanced magnetic anisotropy, cf. paragraphs [0085]–[0092] of the description of the present application.

   ---

2. claim: 8

   A third magnetic layer in contact with the insulator layer induces interfacial anisotropy and thereby reduces the constraints on aspect ratio, cf. paragraph [0093] of the description of the present application.

   ---

3. claim: 9

   A ferromagnetic shell reduces stray field effects, cf. paragraphs [0098]–[00109] of the description of the present application.

   ---

## ANNEX TO THE EUROPEAN SEARCH REPORT
## ON EUROPEAN PATENT APPLICATION NO.

EP 22 20 4792

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2023

| Patent document cited in search report | | Publication date | Patent family member(s) | | Publication date |
|---|---|---|---|---|---|
| US 2018108706 | A1 | 19-04-2018 | NONE | | |
| TW 201133757 | A | 01-10-2011 | NONE | | |
| US 2022263013 | A1 | 18-08-2022 | CN | 113450848 A | 28-09-2021 |
| | | | DE | 102020119132 A1 | 16-12-2021 |
| | | | KR | 20210154685 A | 21-12-2021 |
| | | | TW | I748767 B | 01-12-2021 |
| | | | US | 2021391530 A1 | 16-12-2021 |
| | | | US | 2022263013 A1 | 18-08-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **N. PERRISSIN.** A highly thermally stable sub-20 nm magnetic random-access memory based on perpendicular shape anisotropy. *Nanoscale,* 2018, vol. 10, 12187-12195

- **M. BELEGGIA et al.** Demagnetizing factors for cylindrical shells and related shapes. *Journal of Magnetism and Magnetic Materials,* 2009, vol. 321, 1306-1315